# EUROPEAN PATENT APPLICATION

(11) **EP 0 968 979 A1**
(43) Date of publication of application: **05.01.2000**
(21) Application number: 99112206.0
(22) Date of filing: 25.06.1999
(51) Int. Cl.: C04B 41/53, C09K 13/08

(54) **Etching of Bi-based metal oxides ceramics**

(30) Priority: 30.06.1998 US 109264
(71) Applicant: SIEMENS AKTIENGESELLSCHAFT, 80333 München (DE)
(72) Inventor: Hintermaier, Frank, 81547 München (DE)
(74) Representative: Patentanwälte Westphal, Mussgnug & Partner

(57) **Abstract**

An etching solution comprising fluoride and nitric acid is employed to pattern or remove Bi-based oxide ceramics. The etching solution can be mixed with H₂O to adjust the etch rate. Additionally, inorganic components can be included to increase or decrease the etch rate. Organic components can be included to regulate the wetting/adhesion properties of the etch chemistry.

## Description

### Field of the Invention

The invention relates to Bi-based oxide ceramic materials used in, for example, the manufacturing of integrated circuits (ICs). More particularly, the present invention relates to patterning or removing of Bi-based oxide ceramic materials from wafer substrates or from tools.

### Background of the Invention

Bi-based oxide ceramics being or capable of being transformed into ferroelectric materials have been investigated for their use in ICs due to their high remanent polarization (2Pᵣ) characteristics and long term storage reliability. Various techniques, such as sol-gel, chemical vapor deposition (CVD), sputtering, pulsed laser deposition (PLD), and evaporation, have been developed for depositing films on a substrate. The as-deposited Bi-based oxide ceramic films typically exhibit no ferroelectric properties. The as-deposited films often require post processing, referred to as a "ferroanneal," in order to transform them into ferroelectric films.

In the fabrication of ICs, it is desirable to be able to pattern the Bi-based ferroelectric layer in order to form the appropriate structures of features. However, conventional etch chemistries, such as those described in US Patent 4,759,823, are unable to pattern Bi-based ferroelectric materials. This limits the ability to effectively produce ICs incorporating Bi-based ferroelectric materials.

In addition, Bi-oxide ceramic material are often deposited on the backside of the wafer and in tools used in the processing of such materials. Unwanted deposition of the Bi-oxide ceramic materials on the backside of the wafer and tools leads to cross-contamination and particle formation, which adversely affects yields.

In view of the foregoing discussion, it is desirable to provide an etch chemistry to effectively pattern or remove Bi-based oxide ceramic materials.

### Summary of the Invention

The invention relates to an etch chemistry comprising fluoride (F) and nitric acid which is employed to pattern or remove Bi-based oxide ceramics. In one embodiment, the etch chemistry comprises a pH of less than about 7. The etch chemistry is made from mixing NH₄F, NH₄HF₂ or other F source with an aqueous solution of 30-100% HNO₃. The etch chemistry can be diluted with H₂O to adjust acidity, thereby adjusting the etch rate. In some embodiments, inorganic and organic components can be added to the diluted or non-diluted etch solution to control its acidity and wetting/adhesion characteristics.

### Brief Description of the Drawing

Fig. 1 is a ferroelectric memory cell in accordance with one embodiment of the invention; and
Figs. 2a-e show a process for forming a ferroelectric memory cell in accordance with one embodiment of the invention; and
Fig. 3 shows an alternative process for forming a ferroelectric memory cell.

### Detailed Description Of The Invention

The invention relates to etch chemistries employed to pattern or remove Bi-based oxide ceramic materials. The etch chemistry is useful in, for example, the manufacture of integrated circuits that incorporates a Bi-based oxide ceramic material or cleaning tools used in the processing of Bi-based ceramic materials.

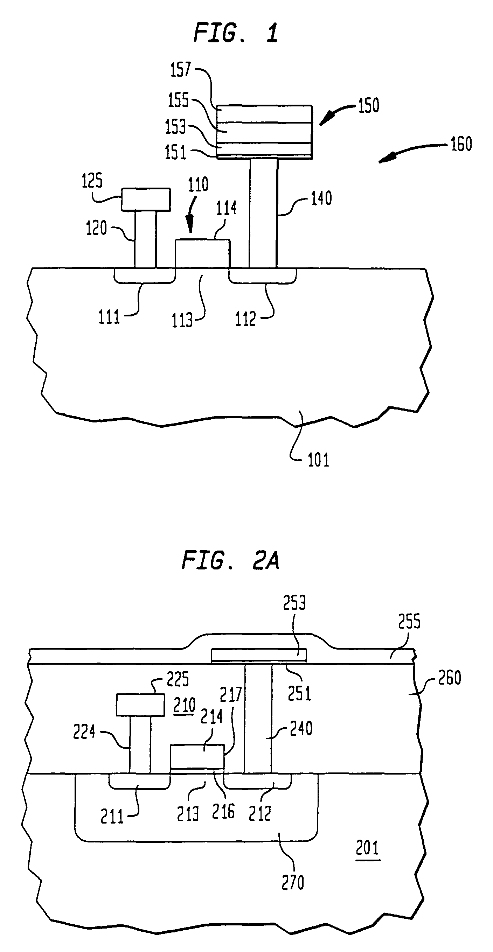

Fig. 1 shows an illustrative ferroelectric memory cell 100 in accordance with one embodiment of the invention. As shown, the memory cell comprises a transistor 110 formed on a substrate 101 such as a semiconductor wafer. The transistor includes diffusion regions 111 and 112 separated by a channel 113, above which is located a gate 114. A gate oxide (not shown) separates the gate from the channel. The diffusion regions comprise dopants which are either p-type or n-type. The type of dopants chosen depends upon the type of transistor desired. For example, n-type dopants such as arsenic (As) or phosphorus (P) are used for n-channel devices, and p-type dopants such as boron (B) are used for p-channel devices. Depending on the direction of current flow between the diffusion regions, one is referred to as the "drain" and the other the "source." The terms "drain" and "source" are herein used interchangeably to refer to the diffusion regions. Typically, the current flows from the source to drain. The gate represents a wordline, and one of the diffusion regions is coupled to a bitline 125 by a contact plug 120.

A capacitor 150 is coupled to diffusion region 112 via a contact plug 140. The capacitor comprises bottom and top electrodes 153 and 157, separated by a ferroelectric layer 155. The ferroelectric layer comprises a Bi-based oxide ceramic. In one embodiment, the Bi-based oxide ceramic comprises strontium bismuth tantalate (SBT) or derivatives of SBT. Typically, the electrodes are formed from noble metal such as, for example, Pt. A conductive barrier layer 151 can be provided between the bottom electrode and contact plug. The barrier layer inhibits the diffusion of oxygen into the contact plug 140. The barrier layer also inhibits 1) the diffusion of atoms from the plug into the ferroelectric layer, and 2) the migration of atoms from the bottom electrode or ferroelectric layer into the plug.

An interlevel dielectric (ILD) layer 160 is provided to isolate the different components of the memory cell. The ILD layer comprises, for example, silicate glass such as silicon dioxide (SiO₂) or silicon nitride (Si₃N₄). Doped silicate glass such as borophosphosilicate glass (BPSG), borosilicate glass (BSG), or phosphosilicate glass (PSG) are also useful. Other types of dielectric materials can also be used.

Applying an appropriate voltage to the gate switches the transistor on, enabling current to flow through the channel between the diffusion regions in order to form a connection between the capacitor and bitline. Switching off the transistor severs this connection, thereby preventing current flowing through the channel.

In some embodiments, a non-semiconductor substrate, such as magnesium oxide (MgO), aluminum oxide (Al₂O₃,), zirconium oxide (ZrO₂), MTiO₃ (where M=Sr, Ba, Pb), is used. Such substrates, for example, serve as a support for electronic devices.

Figs. 2a-e show an illustrative process sequence for forming the memory cell in accordance with one embodiment of the invention. Referring to Fig. 2a, a partially formed memory cell 200 is provided. As shown, the partially formed memory cell includes a transistor 210 formed in a substrate 201. The substrate, for example, is a semiconductor wafer comprising silicon. Other types of substrates such as germanium (Ge), gallium arsenide (GaAs), or other semiconductor compounds are also useful. Typically, the substrate is lightly doped with p-type dopants such as B. More heavily doped substrates are also useful. A heavily doped substrate with a lightly doped epitaxial (epi) layer such as a p-/p+ substrate can also be used. N-type doped substrates comprising arsenic (As) or phosphorus (P), including lightly doped, heavily doped, or heavily doped substrates with a lightly doped epi layer, are also useful.

A doped well 270 comprising dopants having a first electrical type is provided for the transistor 210. The doped well is formed by selectively implanting dopants into the substrate in the region where the transistor is formed. In one embodiment, the doped well is formed by implanting p-type dopants such as B into the substrate. The p-type doped well (p-well) serves as a doped well for n-channel devices. The use of an n-type doped well (n-well) comprising, for example, As or P dopants is also useful for p-channel devices.

The transistor includes diffusion regions 211 and 212 separated by a channel 213. The diffusion regions comprise dopants having a second electrical type. In one embodiment, the diffusion regions comprise p-type dopants such as B. Above the channel is a gate 213 that includes, for example, a gate oxide 216 and a doped polysilicon (poly) layer 217. In some cases, a metal silicide layer (not shown) is formed over the poly, producing a polysilicon-silicide (polycide) stack to reduce sheet resistance. Various metal suicides, including molybdenum (MoSiₓ), tantalum (TaSiₓ), tungsten (WSiₓ), titanium suicide (TiSiₓ) or cobalt suicide (CoSiₓ), are useful. Aluminum or refractory metals, such as tungsten and molybdenum, are used alone or in combination with silicides or poly. A cap dielectric (not shown) comprising, for example, oxide or nitride can be provided over the poly or polycide. The cap dielectric layer can serve as, for example, an etch stop or an implant mask for subsequent processing steps.

A contact plug 220 couples a bitline 225 to diffusion region 211. Above the transistor is an interlevel dielectric layer 260 comprising, for example, silicon oxide or silicon nitride. Various types of doped silicate glass such as such as BPSG, BSG, and PSG, undoped silicate glass, or other dielectric materials are also useful. Coupled to the diffusion region 212 is a contact plug 240, which is formed in the ILD. The contact plugs comprise a conductive material such as doped poly or tungsten (W). Other conductive materials are also useful. Typically, the ILD is planarized to provide a planar top surface.

A barrier layer 251 is formed over the surface of the ILD layer 260 and plug to prevent oxygen from diffusing into contact plug 240. The barrier layer comprises, for example, titanium nitride (TiN). Other materials such as IrSiₓO_{y}, CeO₂/TiSi₂, or TaSiNₓ are also useful.

A conductive layer 253 is formed above the barrier layer. The conductive layer typically comprises a noble metal such as Pt, Pd, Au, Ir, or Rh. Other materials such as conducting metal oxides, conducting metal nitrides, or super conducting oxides which do not react with the ferroelectric layer are also useful. Conducting oxides include, for example, IrOₓ, RhOₓ, RuOₓ, OsOₓ, ReOₓ, or WOₓ (where x is greater than about O and less than about 2). Conducting metal nitrides include, for example, TiNₓ, ZrNₓ (where x is greater than about O and less than about 1.1), WNₓ or TaNₓ (where x is greater than about O and less than about 1.7). Super conducting oxides can include, for example, YBa₂Cu₂0₇₋ₓ or Bi₂Sr₂Ca₂Cu₂O₁₀. The barrier and conductive layers are patterned, forming a bottom electrode.

A Bi-based oxide ceramic layer 255 is deposited over the bottom electrode and ILD layer. The Bi-based oxide ceramic layer is deposited by various known techniques such as, for example, sol-gel or chemical vapor deposition (CVD). Various types of precursors for depositing Bi-based oxide ceramics are useful. Such precursors are described in, for example, co-pending United States Patent Application USSN 08/975,087, titled "Low Temperature CVD Process using B-Diketonate Bismuth Precursor for the Preparation of Bismuth Ceramic Thin Films for Integration into Ferroelectric Memory Devices," which was filed on November 20, 1997; concurrently filed United States Patent Application USSN (attorney docket number 98P6422 US01), titled "Amorphously Deposited Metal Oxide Ceramic Films," which are both herein incorporated by reference for all purposes.

The as-deposited Bi-based oxide ceramic is processed with a ferroanneal to transform it into a ferroelectric layer. Post-deposition processing includes, for example, annealing the Bi-based oxide at a temperature of, for example, about 700-800°C. Lower temperatures and/or shorter annealing times are also possible when transforming an amorphously deposited Bi-based oxide layer into the ferroelectric phase.

The ferroelectric Bi-based oxide ceramic layer comprises, for example, negatively charged perovskite layers separated by positively charged Bi oxide layers. The Bi-based oxide ceramic is expressed by the general formula:

(Bi₂O₂)²⁺(Aₘ₋₁BₘO₃ₘ₊₁)²⁻

where A = Bi³⁺, L³⁺, L²⁺, Ca²⁺, Sr²⁺, Ba²⁺, Pb²⁺, and Na⁺; B = Fe³⁺, Al³⁺, Sc³⁺, Y³⁺, L³⁺, L⁴⁺, Ti⁴⁺, Nb⁵⁺, Ta⁵⁺, W⁵⁺, and Mo⁶⁺; and m = 1, 2, 3, 4, 5. L = a metal from the lanthanide series which includes, for example, Ce, La, Pr, Ho, Eu, and Yb.

In one embodiment, the Bi-based oxide ceramic comprises Ta. In another embodiment, the Bi-based oxide ceramic comprises Sr. Preferably, the Bi-based oxide ceramic comprises Sr and Ta. More preferably, the Bi-based oxide ceramic comprises strontium bismuth tantalate (SBT). In alternative embodiments, the Bi-based oxide ceramic comprises Ti or Ti and Sr. A Bi-based oxide ceramic comprising Sr and Nb or Sr, Ta, and Nb is also useful.

The SBT is expressed by, for example, the formula SrBi₂Ta₂O₉. The ferroelectric Aurivillius phase of the SBT film comprises negatively charged perovskite layers of Sr and Ti oxide separated by positively charged Bi oxide layers. The stoichiometry of the Sr and Ti oxide is, for example, [SrTa₂O₇]²ⁿ⁻ₙ, and the stoichiometry of the Bi oxide layers is, for example, [Bi₂O₂]²ⁿ⁺ₙ, creating a structure of alternating [SrTa₂O₇]²ⁿ⁻ₙ and [Bi₂O₂]²ⁿ⁺ₙ layers.

Bi-based oxide ceramic layers that are derived from SBT are also useful. The SBT derivative is formed by, for example, substituting one or more of the metallic elements with other metallic elements having the same oxidation states. For instance, Ta can be replaced by Nb and Sr can be replaced by Ba, Ca, or Pb, resulting in a compound expressed by the generic formula XBi₂Z₂O₉, where X=Sr, Ba, Ca or Pb and Z= Ta or Nb.

In one embodiment, the SBT derivative comprises Bi and Ta. In another embodiment, the SBT derivative comprises Bi and Sr. In yet another embodiment, the SBT derivative comprises Bi, Sr, and Ta. The SBT derivative comprises, for example, SrBi₂Ta₂₋ₓNbₓO₉ (0<x<2), SrBi₂Nb₂O₉, Sr₁₋ₓBaₓBi₂Ta_{2-y}Nb_{y}O₉ (0≤x≤1, 0≤y≤2), Sr₁₋ₓCaₓBi₂Ta_{2-y}Nb_{y}O₉ (0≤x≤1, 0≤y≤2), Sr₁₋ₓPbₓBi₂Ta_{2-y}Nb_{y}O₉ (0≤x≤1, 0≤y≤2), or SrₐBa_{b}Ca_{c}Pb_{1-a-b-c}Bi₂TaₓNb₂₋ₓO₉ (0≤a+b+c≤1, 0≤x≤2). Other Bi-based ferroelectric materials such as Bi₄Ti₃O₁₂ or SrBi₄Ti₄O₁₅, are also useful.

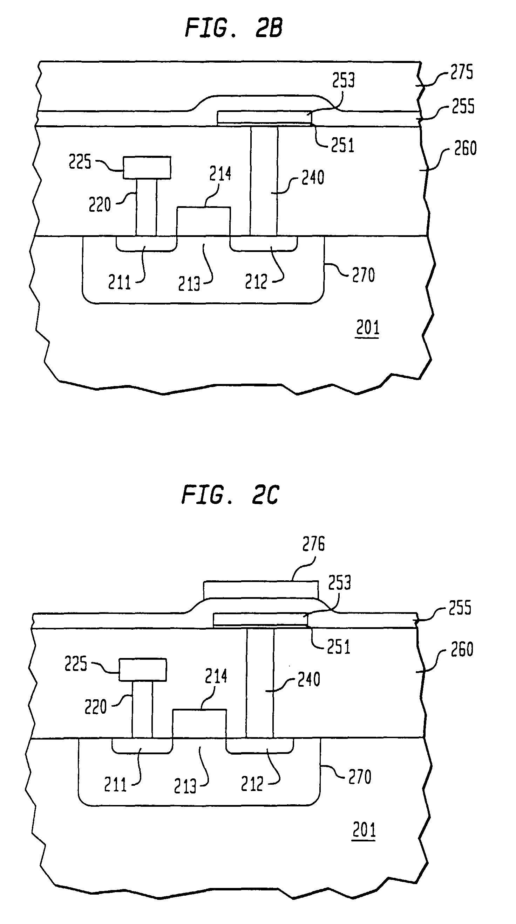

In one embodiment, the ferroelectric Bi-based oxide ceramic is patterned. Referring to Fig. 2b, a mask layer 275 is deposited over the ferroelectric layer 255. The mask layer comprises, for example, a photoresist. Other types of mask layers, such as a hard mask comprising TEOS or other appropriate materials, are also useful.

Referring to Fig. 2c, the mask layer is patterned, leaving a portion 276 covering the ferroelectric Bi-based oxide ceramic layer over the bottom electrode. In one embodiment, the portion 276 overlaps the bottom electrode. The overlap produces a sidewall spacer to insulate the subsequently deposited top electrode from the bottom electrode. Other techniques for forming insulating sidewall spacers are also useful. Patterning of the photoresist layer is achieved by selective exposure to radiation with an exposure source and mask. The exposed or unexposed portions of the resist layer are removed, depending on whether a positive or negative resist is used. In alternative embodiments employing a hard mask layer, a patterned photoresist layer is used as an etch mask to pattern the hard mask in order to expose selected portions of the bottom electrode.

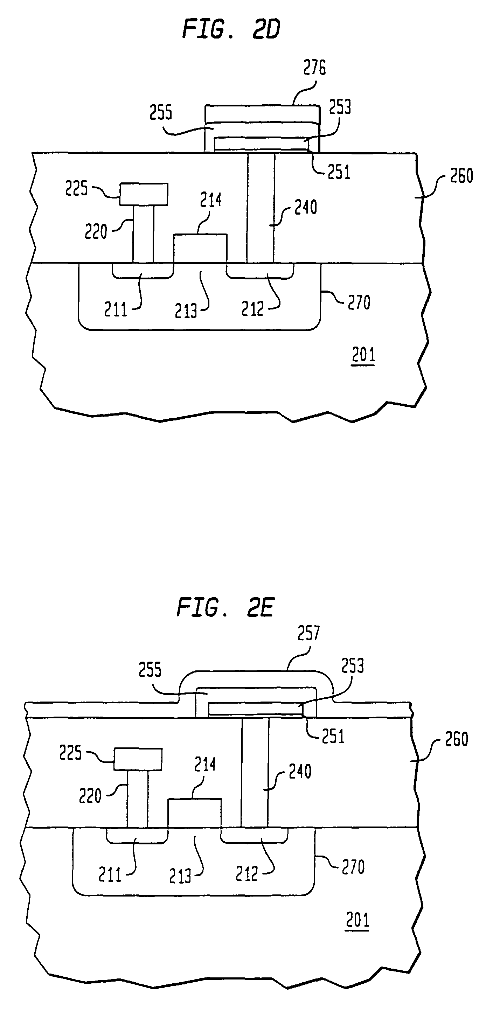

In Fig. 2d, the ferroelectric layer is patterned. As shown, the portions of the ferroelectric layer unprotected by the mask layer are removed by a wet etch, exposing the ILD layer 260 thereunder. The portion of the ferroelectric layer protected by the mask layer remains to cover the bottom electrode.

In accordance with the invention, the wet etch utilizes a chemistry comprising fluoride (F) in an acidic medium. In one embodiment, the wet etch chemistry includes a solution of F in an acidic medium comprising nitric acid (HNO₃). Various F sources can be combined with HNO₃ to form a nitric fluoride solution. Such F sources include, for example, HF, NH₄F, or NH₄HF₂.

In one embodiment, the pH of the nitric fluoride etch solution is less than about 7 and preferably less than or equal to about 5. Other pH values such as less than or equal to about 3, less than or equal to about 0, and less than or equal to about -1 are also useful. Increasing the acidity of the etch solution increases the etch rate. The pH, or course, can be optimized to achieve the desired etch rate for a specific process.

In one embodiment, the nitric fluoride chemistry comprises HNO₃ and NH₄F. A nitric fluoride chemistry comprising HNO₃ with NH₄HF₂ is also useful. Combining other types of F sources, such as HF, with HNO₃ is also useful.

The nitric fluoride etch chemistry has been found to be effective in patterning the ferroelectric material. The reason that the etch chemistry effectively patterns the ferroelectric material is believed to be due to the presence of fluoride ions in an acidic environment. The acidic environment partially protonates the oxide ions of the ferroelectric material, partially producing ions of the hydroxide groups. The fluoride ions in the solution exchanges with the hydroxide ions since they have similar ionic ratio, forming fluoro complexes. The resulting fluoro complexes are soluble in acidic environment, enabling the ferroelectric material to be etched away by the chemistry.

In some cases, SrF₂ is formed due to the presence of SrO. Although the solubility of SrF₂ is relatively low, it increases as pH value decreases. Therefore, applying an etch solution with a low pH is useful as this will keep Sr in the solution.

In one embodiment, the wet etch chemistry comprises a solution of HNO₃ and NH₄F. The NH₄F is mixed in an aqueous solution of 30-100% HNO₃ (all percentages used herein are mass percentages), preferably about 50-80% aqueous solution of HNO₃, more preferably about 60-70% aqueous solution of HNO₃, and more preferably about 65% aqueous solution of HNO₃. The composition of NH₄F is about 3-30% of the total weight of the solution, preferably about 8-25% of the total weight of the solution, more preferably about 10-20% of the total weight of the solution, more preferably about 12-18% of the total weight of the solution, and more preferably about 15.5% of the total weight of the solution.

In another embodiment, the wet etch chemistry comprises a solution of HNO₃ and NH₄HF₂. The NH₄F is mixed in an aqueous solution of 30-100% HNO₃ (all percentages used herein are mass percentages), preferably about 50-80% aqueous solution of HNO₃, more preferably about 60-70% aqueous solution of HNO₃, and more preferably about 65% aqueous solution of HNO₃. The composition of NH₄HF₂ is about 5-40% of the total weight of the solution, preferably about 10-30% of the total weight of the solution, more preferably about 15-25% of the total weight of the solution, and more preferably about 21.4% of the total weight of the solution.

The etch solution can be diluted with H₂O to adjust the etch rate as desired. Diluting the etch solution decreases its acidity, thereby decreasing the etch rate. In one embodiment, 1 part etch solution is diluted with 1-5 parts H₂O. A mixture of 1 part etch solution with 1-4 parts H₂O, 1 part etch solution with 1-3 parts H₂O, 1 part etch solution with 1-2 parts H₂O, or 1 part etch solution with 1 part H₂O is also useful.

An inorganic ionic component can be added to the diluted or non-diluted etch solution. Such inorganic components are used to control the pH of the etch solution. The inorganic ionic components, depending on their characteristics, further acidify or buffer the etch solution to maintain its acidity as desired. In one embodiment, inorganic ionic components include compounds such as NH₄Cl, NH₄Br, HCl, and H₂SO₄. NH₄Cl and NH₄Br are used as buffers, and HCl and H₂SO₄ are used to increase the acidity of the etch solution. Mixing more than one inorganic components in the etch solution is also useful. Typically the composition of the inorganic component or components is about 1-30% of the total mass of the etch solution. In one embodiment, NH₄Cl and/or NH₄B of about 1-30% of total mass of the etch solution is added to buffer the diluted or non-diluted etch solution. In another embodiment, adding HCl and H₂SO₄ in the amount of about 1-30% of the total mass of the etch solution to increase its acidity is also useful.

One or more organic compounds can also be added to the diluted or non-diluted etch chemistry to modify the surface tension of the ferroelectric material. This enables the regulation of the wetting/adhesion properties of the etch. In one embodiment, organic compounds include alcohol such as ethanol or isopropanol. Organic components such as acids, including acetic acid and propionic acid, are also useful. Other organic components such as ketones, including acetone and diethylketone, are also useful. Typically the composition of the organic component or components is about 1-30% of the total mass of the etch solution.

After etching the Bi-based oxide ceramic, the substrate is rinsed with water. A mixture of Isopropanol/water is also useful to rinse the substrate.

Referring to Fig. 2e, the mask layer is removed using, for example, a wet etch. For applications employing a hard mask, a reactive ion etch (RIE) is used to remove the mask. A top electrode 257 is deposited, covering the ferroelectric Bi-based oxide ceramic layer and ILD layer 260. The top electrode, like the bottom electrode, comprises a conductive material that does not react with the Bi-based oxide ceramic layer. Additional processing is performed to complete the ferroelectric memory IC. Such additional processing is known in the art. For example, the additional processing includes forming support circuitry, contact openings to the bitline, final passivation layer, contact openings in the passivation layer for testing and connecting to lead frame, and packaging.

In an alternative embodiment, the Bi-based oxide ceramic layer as described in Fig. 2a is not annealed after deposition to transform it into a ferroelectric layer. The Bi-based oxide is selectively etched with a nitric fluoride solution as described. In one embodiment, the nitric fluoride solution comprises HNO₃ and NH₄F or NH₄HF. Other F sources can also be used with HNO₃ to form the nitric fluoride chemistry.

The non-annealed Bi-based oxide is typically easier to etch than the annealed Bi-based oxide. As such, a diluted etch solution can be used to achieve the desired etch rate. In one embodiment, the nitric fluoride etch solution is diluted with H₂O. A diluted nitric fluoride etch solution of about 1 part etch solution with 5-100 parts H₂O has been found to be effective to etch a non-annealed Bi-based oxide ceramic. A diluted nitric fluoride etch solution comprising, for example, 1 part etch solution mixed with 8-80 parts H₂O, 1 part etch solution mixed with 10-50 parts H₂O, or 1 part etch solution mixed with 10-20 parts H₂O is useful. Mixing the etch solution with organic or inorganic components are also useful to achieve the desired etch rate and wetting/adhesion characteristics.

After etching the Bi-based oxide ceramic material, the mask layer is removed. The Bi-based oxide ceramic material is annealed to transform it into a ferroelectric material. The process continues as described from Figs. 2b-e.

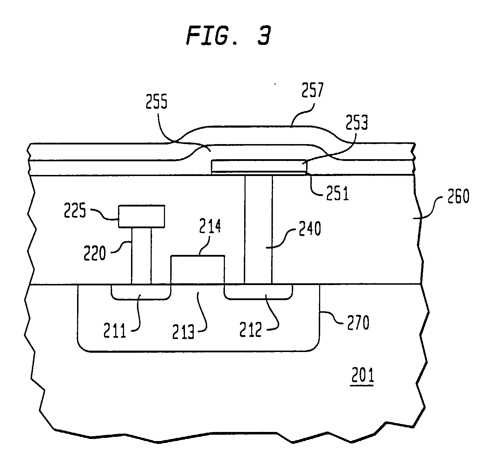

In an alternative embodiment, the Bi-based oxide ferroelectric layer 255 is not etched after being deposited and post processed over the bottom electrode. A top electrode 257 is deposited over the Bi-based oxide ceramic, as shown in Fig. 3. The top electrode is patterned, as desired, to expose portions of the ferroelectric Bi-based oxide ceramic to provide access to, for example, the bitline and wordline. The exposed portions of the ferroelectric Bi-based oxide ceramic layer are removed by the wet etch chemistry in accordance with the invention.

Additional processing is performed to complete the ferroelectric memory IC. Such additional processing is known in the art. For example, the additional processing includes forming support circuitry, contact openings to the bitlines and wordlines, final passivation layer, contact openings in the passivation layer for testing and connecting to lead frame, and packaging.

The etch chemistry in accordance with the invention is also useful in patterning or removing non-ferroelectric Bi-based oxide ceramics. Such non-ferroelectric Bi-based layers include, for example, a Bi-based high temperature superconductor layer. Bi-based high temperature superconductor layers are known as, for example, "BSCCO" or "bissco." Typical compositions of BSCCO include, for example, Bi₂Sr₂CaCu₂Oₓ or (Pb,Bi)₂Sr₂Ca₂Cu₃Oₓ. Other compositions of BSCCO include, for example, Bi₂Sr₂CuOₓ and Bi₂Sr₂Ca₃Cu₄Oₓ. The nitric fluoride chemistry is also effective in etching or removing other types of Bi-based oxide ceramics.

In the processing of Bi-based oxide ceramic materials, oxides are deposited in various parts of the chamber of the tool such as the walls and susceptor. For example, oxides such as SrO, Bi₂O₃, and Ta₂O₅ are often deposited on the walls and other portions of the chamber such as the susceptor during the deposition of SBT. Annealing furnaces for post-deposition processing of SBT are also subjected to oxide deposition on, for example, the furnace walls. The deposition of oxides on the tools can be detrimental to their performance in the processing of Bi-based oxide ceramics, adversely affecting yields.

The etch chemistry comprising F and HNO₃ as described in accordance with the invention can be utilized in cleaning tools used in the processing of Bi-based oxide ceramics. Various F compounds, such as NH₄F and NH₄HF₂, are useful. The nitric fluoride etch chemistry is effective in removing unwanted oxide deposition on various parts of the tools. A diluted or non-diluted etch solution can be used, depending on, for example, whether the deposits are in a reactor or an anneal furnace. A more concentrated etch solution is used to remove deposits which are more difficult to clean.

In one embodiment, the etch chemistry comprises nitric acid solution. The etch chemistry comprises about 30% aqueous HNO₃. This has been found effective in removing unwanted oxide deposits from the walls of the reactor. F can be added to the nitric acid solution. In one embodiment, HF is added to the nitric acid solution. In one embodiment, about 0.5-10% aqueous HF is added to the aqueous HNO₃.

The chemistry is, for example, applied to the walls of the reactor at room temperature. The duration of the application depends, for example, on the amount of unwanted deposits on the chamber walls. If applying to stainless steel, the application should not exceed about 10 minutes. Applying the etch solution for more than 10 minutes may corrode the stainless steel chamber walls. The walls are then rinsed with water, removing the etch solution and deposits.

An HCl solution can optionally be applied after the application of the etch solution. The HCl is used to remove last residue. In one embodiment, the HCl solution comprises about 0.5-10% aqueous HCl. If applied to stainless steel, the HCl solution should be applied for less than or equal to about 1 minute. The walls are rinsed with water to remove the HCl and etch solutions.

Removal of oxide deposits on the susceptor may require a more concentrated or acidic etch solution. In one embodiment, the etch solution comprising about 65% HNO₃ has been found to be effective in removing oxide deposits from the susceptor. Applying a solution of HF over the etch solution is also useful. The HF solution comprises about 35-50% aqueous HF. In one embodiment, the etch solution comprises HNO₃ and HF. The solution is generated by, for example, mixing 1-10 parts 65% HNO₃ with 1-10 parts 50% HF.

To clean oxide deposits from tools used for post deposition processing of Bi-based oxide ceramics, an undiluted solution or less diluted solution can be used as the deposits have been annealed and require more acidic solutions to remove.

Applying the etch solutions at temperatures greater than room temperature, for example, 30-80°C is also useful. At higher temperatures, a more diluted solutions can be used.

In one embodiment, the etch solutions are applied to the walls and other parts of the tool manually. Other techniques for applying the etch solutions are also useful. For example, the application of the etch solutions and rinse solutions can be integrated into the tool, such as using injectors to apply the solutions to the desired parts of the tools to remove the unwanted deposits.

### Experiments

Experiments were conducted to etch ferroelectric Bi-based oxide ceramic with different fluoride based chemistries in a HNO₃ acidic medium. Mixture A comprised 1.25g NH₄F dissolved in 6.8g 65% HNO₃. Mixture B comprised 1.9g NH₄HF dissolved in 7g 65% HNO₃. Other chemistries were derived by diluting the mixtures with 1 and 2 parts of H₂O.

The chemistries were used to etch Bi-based oxide ceramics. A 120 nm thick SrO/Bi₂O₃/Ta₂O₅ film was deposited by CVD at 420°C on a Pt electrode that was formed on a substrate. The film comprised composition of 18%Sr, 45%Bi and 37%Ta. The film was annealed at 800°C for about 1 hour in an O₂ ambient. A 2x2 cm² sample of the Bi ceramic film was removed by application of about 10 drops of the etch mixtures, exposing the Pt electrode. The substrate was rinsed with deionized water and subsequently rinsed with acetone to remove the water and facilitate drying. The etching times required to exposed the Pt electrode are recorded in Table 1.

**Table 1**

| Etch Chemistry | Etch Time (seconds) |
|---|---|
| Mixture A | 10 |
| Mixture A with H₂O (1:1) | 30 |
| Mixture A with H₂O (1:2) | 90 |
| Mixture B | 5 |
| Mixture B with H₂O (1:1) | 20 |
| Mixture B with H₂O (1:2) | 60 |

An x-ray fluorescence (XRF) analysis shows that no oxide residues are present on surfaces etched with mixtures that were diluted with H₂O. In some cases, some oxide residues are present on surfaces etched with non-diluted mixtures. The existence of oxide residue on the etched surface depends on the composition and pretreatment of the film. However, HCl can be used to remove the oxide residue.

While the invention has been particularly shown and described with reference to various embodiments, it will be recognized by those skilled in the art that modifications and changes may be made to the present invention without departing from the spirit and scope thereof. The scope of the invention should therefore be determined not with reference to the above description but with reference to the appended claims along with their full scope of equivalents.

## Claims

1. An etch solution for removing Bi-based oxide ceramic, the etch solution comprises fluoride and nitric acid.

2. The etch solution as recited in claim 1 wherein the fluoride comprises NH₄F.

3. The etch solution as recited in claim 2 wherein the compositional amount of NH₄F is about 3-30% of the total mass.

4. The etch solution as recited in claim 3 wherein the compositional amount of nitric acid is about 30-100% by mass before mixing with NH₄F.

5. The etch solution as recited in claim 4 is further mixed with H₂O to form a diluted etch solution.

6. The diluted etch solution as recited in claim 5 comprises about 1 part etch solution and about 1-5 parts H₂O.

7. The etch solution as recited in claim 4 further comprises an inorganic component to control the acidity of the etch solution.

8. The etch solution as recited in claim 7 wherein the inorganic component comprises NH₄Cl, NH₄Br, HCl, and/or H₂SO₄.

9. The etch solution as recited in claim 4 further comprises an organic component, the organic component regulates the wetting/adhesion properties of the etch solution.

10. The etch solution as recited in claim 9 wherein the organic component comprises ethanol, isopropanol, acid, and/or ketones.

11. The etch solution as recited in claim 1 wherein the fluoride comprises NH₄HF₂.

12. The etch solution as recited in claim 11 wherein the compositional amount of NH₄HF₂ is about 3-30% of the total mass.

13. The etch solution as recited in claim 12 wherein the compositional amount of nitric acid is about 30-100% by mass before mixing with NH₄HF.

14. The etch solution as recited in claim 13 is further mixed with H₂O to form a diluted etch solution.

15. The diluted etch solution as recited in claim 14 comprises about 1 part etch solution and about 1-5 parts H₂O.

16. The etch solution as recited in claim 13 further comprises an inorganic component to increase or decrease the acidity of the etch solution.

17. The etch solution as recited in claim 16 wherein the inorganic component comprises NH₄Cl, NH₄Br, HCl, and/or H₂SO₄.

18. The etch solution as recited in claim 13 further comprises an organic component, the organic component regulates the wetting/adhesion properties of the etch solution.

19. The etch solution as recited in claim 18 wherein the organic component comprises ethanol and/or isopropanol

20. The etch solution as recited in claims 1-19 is used in cleaning tools employed in the processing of the Bi-based oxide ceramic.

21. The etch solution as recited in claims 1-19 is used in etching Bi-based oxide ceramic on the backside of the wafer.

22. A method of fabricating a integrated circuit comprises:
depositing a Bi-based oxide ceramic layer on a substrate; and
patterning the Bi-based oxide with an etch chemistry comprising an etch solution of F in an acidic medium comprising nitric acid.

23. The method as recited in 22 further comprises annealing the substrate after the Bi-based oxide ceramic layer is deposited thereon.

24. The method as recited in claim 23 wherein the fluoride comprises NH₄F.

25. The etch solution as recited in claim 24 wherein the compositional amount of NH₄F is about 3-30% of the total mass.

26. The etch solution as recited in claim 25 wherein the compositional amount of nitric acid is about 30-100% by mass before mixing with NH₄F.

27. The method as recited in claim 26 wherein the solution is diluted with H₂O to decrease the etch rate.

28. The method as recited in claim 27 wherein the diluted solution comprises about 1 part etch solution and 1-5 about parts H₂0.

29. The method as recited in claim 28 wherein the integrated circuit comprises a ferroelectric memory cell.

30. The method as recited in claim 29 wherein the Bi-based oxide ceramic layer is deposited on a bottom electrode of a ferroelectric capacitor, the bottom electrode comprises a conductive material that does not react with the Bi-based oxide ceramic layer

31. The method as recited in claim 30 further comprises:
depositing top electrode over the Bi-based oxide ceramic; and
subsequent processing to complete the ferroelectric memory cell.

32. The etch solution as recited in claim 22 wherein the compositional amount of NH₄F is about 3-30% of the total mass.

33. The etch solution as recited in claim 29 wherein the compositional amount of nitric acid is about 30-100% by mass before mixing with NH₄F.

34. The method as recited in claim 30 wherein the etch solution is diluted with H₂O, wherein the diluted solution comprises about 1 part etch solution and about 5-100 parts H₂O

35. The method as recited in claim 34 wherein the integrated circuit comprises a ferroelectric memory cell.

36. The method as recited in claim 35 wherein the Bi-based oxide ceramic layer is deposited on a bottom electrode of a ferroelectric capacitor, the bottom electrode comprises a conductive material that does not react with the Bi-based oxide ceramic layer

37. The method as recited in claim 36 further comprises:
depositing top electrode over the Bi-based oxide ceramic; and
subsequent processing to complete the ferroelectric memory cell.

38. The method as recited in claim 22 wherein the Bi-based oxide ceramic is deposited on the backside of the wafer.

39. A method of cleaning deposits from tools used in the processing of Bi-based oxide ceramic, the method comprises:
applying a nitric fluoride chemistry to the tools; and
rinsing the nitric fluoride chemistry to remove the deposits from the tool.
